# EUROPEAN PATENT SPECIFICATION

(11) **EP 0 489 203 B1**
(45) Date of publication and mention of the grant of the patent: **11.09.1996**
(21) Application number: 90313121.7
(22) Date of filing: 03.12.1990
(51) Int. Cl.: C08F 299/00, C08F 2/46, C09D 4/00, C09J 4/00

(54) **Active energy ray-curable type resin composition**
Strahlenhärtbare Harzzusammensetzung
Composition de résine durcissable par rayonnement actif

(43) Date of publication of application: 10.06.1992
(73) Proprietor: DAINIPPON INK AND CHEMICALS, INC., Itabashi-ku Tokyo (JP)
(72) Inventor: Ichinose, Eiji, Ichihara-shi, Chiba-ken (JP); Motomura, Masatoshi, W-6000 Frankfurt/Main 1 (DE); Ishikawa, Hidenobu, Ichihara-shi, Chiba-ken (JP)
(74) Representative: Cresswell, Thomas Anthony

(56) References cited:
- WPIL, FILE SUPPLIER, AN=91-085436, Derwent Publications Ltd, London, GB; & SU-A-1 558 937
- WPIL, FILE SUPPLIER, AN=90-135778, Derwent Publications Ltd, London, GB; & JP-A-02 083 818
- WPIL, FILE SUPPLIER, AN=90-077078, Derwent Publications Ltd, London, GB; & EP-A-358 358
- WPIL, FILE SUPPLIER, AN=89-210096, Derwent Publications Ltd, London, GB; & JP-A-01 146 966

## Description

This invention relates to a novel and useful active energy ray-curable composition. More specifically, it relates to an active energy ray curable composition which has excellent pigment dispersibility and adhesion and is useful as a binder component for use in a paint, an adhesive, printing ink or a magnetic recording medium, said resin composition comprising a resin having a cyclocarbonate group and an alpha,beta-ethylenically unsaturated double bond (to be sometimes referred to as an " unsaturated bond ") in a molecule as an essential film-forming component.

In recent years, resins curable with active energy rays have come into wide acceptance in fields of a paint, an adhesive and a printing ink in particular.

This is because of a number of advantages, for example, such an active energy-ray curable resin has a high speed of curing, can be cured without heating, and can be used in the absence of a solvent, and it has good storage stability.

A resin composition crosslinkable under the action of active energy rays, now in use, comprises a combination of a (meth)acrylic oligomer having a (meth)acryloyl (oxy) group with various reactive diluents such as a monomer having one unsaturated bond per molecule (a monofunctional monomer) and/or a monomer having at least two unsaturated bonds per molecule (polyfunctional monomer), as required in further combination with photo(polymerization) initiators or (photo)sensitizers, and other additives. Typical examples of the (meth)acryllic oligomers include polyester (meth)acrylates, polyurethane (meth)acrylates, epoxy (meth)acrylates and polyether (meth)acrylates.

SU-1558937 describes compositions for the preparation of electroluminescent layers. The compositions comprise a polymer binder based on a precopolymer derived from allyloxymethyl cyclocarbonate. JP 20-83818 relates to a binder for magnetic recording media, which is composed of a polyurethane resin having a cyclocarbonate group in it. The resin is cured by solvent evaporation. JP 11-46966 discloses a resin composition for paint, of which one component contains a polymerisable unsaturated group and a cyclocarbonate group, and a second component contains a ketimine group. The composition is heat-cured by the reaction between the ketimine and the cyclocarbonate group.

When the properties of cured films, such as chemical resistance and mechanical properties (such as break strength, break elongation and moduli of elasticity) are taken into consideration, the polyurethane (meth)acrylate-type resins containing an urethane bond, having a large cohesive force between molecules, may be superior among them.

However, the conventional polyurethane (meth)acrylate-type resins have insufficient adhesion to various plastics, metals and wooden materials, and in addition have insufficient dispersibility in inorganic fillers, inorganic pigments and magnetic powders. Accordingly, these resins are very inconvenient in utilizing them as a binder for paints or adhesives.

As methods of improving the adhesion to various materials and improving the dispersibility of various additives, it is the practice to introduce strongly electrolytic inorganic components, having specific groups such as -SO₃M and -COOM wherein M represents an alkali metal, acid components such as carboxylic acid and phosphoric acid, or various organic polar groups such as a primary or secondary amine or a hydroxyl group into the resin skeleton.

However, the introduction of such strongly electrolytic inorganic components, such acid components or such organic polar groups results in facilitating the hydrolysis of an ester linkage or an urethane linkage in the resin skeleton or causes reaction with the (meth)acryloyl(oxy) group. This adversely affects the storage stability as a resin and a resin composition (paint) and properties of a cured coated film. Accordingly, introduction of such components or groups is not desirable.

It is therefore an object of this invention to eliminate the various defects of the prior art, and to provide a very useful active energy ray-curable resin composition which is useful as paints of this type, adhesives, printing ink and magnetic recording media.

It is another object of this invention to provide a greatly improved and very useful active energy ray-curable resin composition which is (a) non-electrolytic, (b) non-oxidising and non-basic, and (c) chemically inert in practice, and which provides new means of improving adhesion and dispersibility.

The present inventors conducted extensive further investigations in order to achieve these objects.

Consequently, these investigations have led to the discovery that a resin composition comprising a specified organic polar group (reactive polar group) as an essential film-forming component has the basic properties (a), (b) and (c), and has excellent adhesion to various plastic materials and products typified by PET films, various metal materials and products typified by tinplate, various timbers typified by Japanese oak and worked products, as well as the excellent dispersibility of inorganic fillers such as titanium dioxide and magnetic powder.

Thus, according to this invention, there is provided an active energy ray-curable composition comprising a resin having a cyclocarbonate group, an alpha,beta-ethylenically unsaturated double bond and an urethane bond in the molecule as an essential film-forming component, the resin being obtainable by reacting together (i) a diol having a molecular weight of 500 to 4000, (ii) a diol containing a cyclocarbonate group, (iii) an isocyanate compound, and (iv) a compound having an unsaturated bond and a hydroxyl group.

The invention also provides a composition comprising a resin having a cyclocarbonate group, an alpha,beta-ethylenically unsaturated double bond and an urethane bond in the molecule, the resin being obtainable by reacting together (i) a diol having a molecular weight of 500 to 4000, (ii) a diol containing a cyclocarbonate group, (iii) an isocyanate compound, and (iv) a compound having an unsaturated bond and a hydroxyl group.

The cyclocarbonate group may be of the general formula 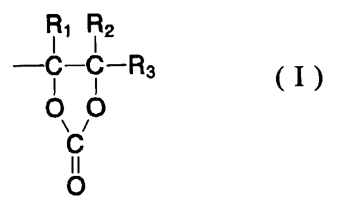 wherein R₁, R₂ and R₃ may be the same or different, and each represents a hydrogen atom, or an aliphatic, aromatic or alicyclic monovalent hydrocarbon group, and R₁ and R₂ or R₁ and R₃ may together represent a 5-membered or 6-membered cyclic hydrocarbon group.

In the above general formula, R, R₂ and R₃ may be the same or different, and each of R₁, R₂ and R₃ preferably represents a hydrogen atom or a lower alkyl group.

As a general principle, a resin having a cyclocarbonate group and an unsaturated bond may be prepared by means of a known basic chemical reaction, such as those shown below: 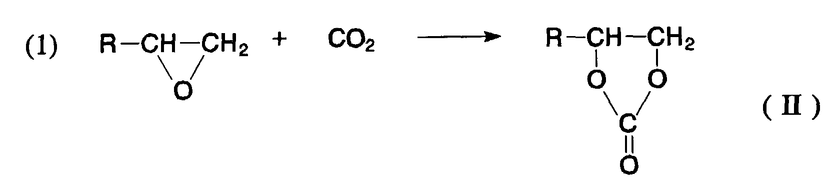 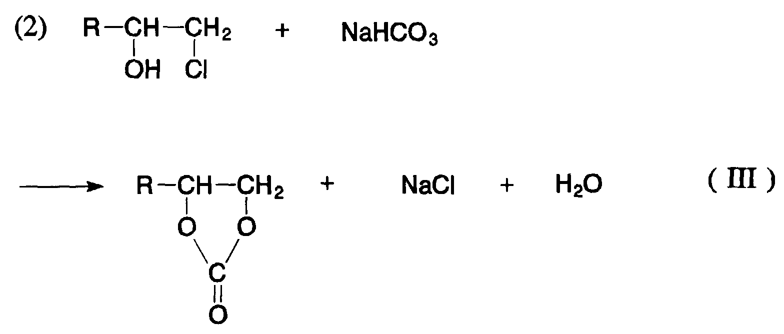 (R in the two formulae represent a monovalent organic group).

Examples of the compound represented by the following formula, used in the reaction (1) 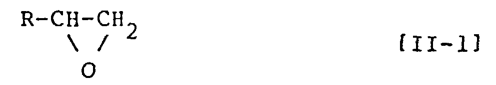 (R is as defined above.)
are compounds having an unsaturated bond in R, for example, glycidyl compounds or derivatives thereof, such as glycidyl (meth)acrylate.

In this way, via the reactions (1) and (2), a compound having a cyclocarbonate group, represented by the following formula 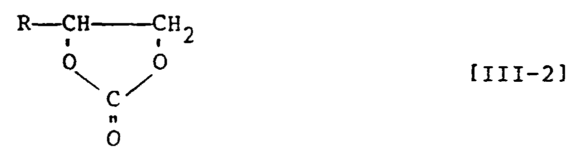 wherein R is as defined above,
is formed and an unsaturated bond is then introduced into R to obtain a resin having a cyclocarbonate group and an unsaturated bond in a molecule.

At that time, a glycidyl compound or a derivative thereof may be utilized as the compound of formula [II-1]. The starting materials that can be used are abundant. On the other hand, the compound of formula [III-1] used in the reaction (2) 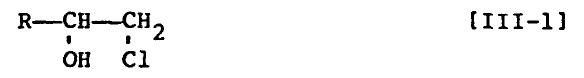 wherein R is as defined above,
may be produced by utilizing the chemical reactions (1) to (3) shown below, and therefore obtained in abundance. 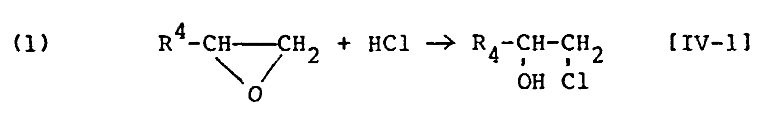 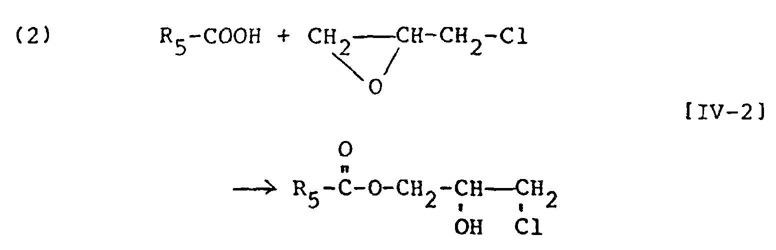 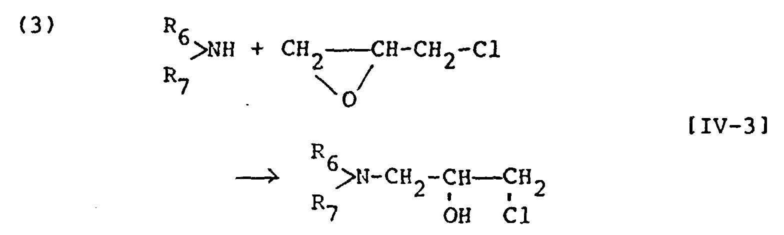 wherein R₄, R₅, R₆ and R₇ each represent an organic group.

In the production of a resin as described above, a diol monomer containing a cyclocarbonate group is formed, and then the resin is derived from it.

Examples of the diol monomer containing a cyclocarbonate group are typically compounds of the following formula that can be synthesized from, for example, dimethylolpropionic acid 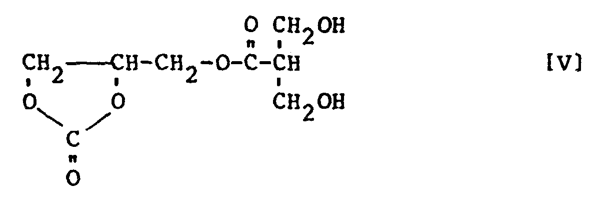 and compounds of the following formula which can be synthesized from diethanolamine.

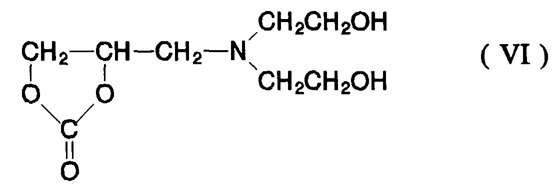

To prepare the resin contained in the compositions of the present invention, which resins simultaenously contain a cyclocarbonate group, an alpha-beta ethylenically unsaturated bond and a urethane bond per molecule, a conventional synthesizing method may be followed employing a diol monomer containing a cyclocarbonate group as part of the material for the diol. A compound containing both an unsaturated bond and a hydroxyl group is also used. The method may be carried out in accordance with a reaction between the hydroxyl group and the isocyanate group (urethanization reaction). As one example, when a compound of the above formula (VI) is used, there can be obtained a resin comprising a cyclocarbonate group, a urethane linkage and an alpha-beta ethylenically unsaturated bond, namely have the following formula:

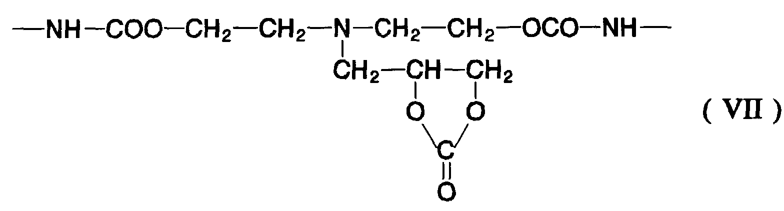

Examples of the diol used to prepare the resin contained in compositions of the invention include various high-molecular-weight diols such as polyester-type diols, polyether-type diols and caprolactane-type diols. These high-molecular-weight diols have a molecular weight of 500 to 4,000.

The polyester-type diols may be synthesized from low-molecular-weight diols and difunctional carboxylic acids such as adipic acid, succinic acid, sebacic acid, terephthalic acid and isophthalic acid as starting materials.

Typical examples of the isocyanate compounds used together with the diols include diisocyanate compounds having an aromatic ring such as 2,4-tolylene diisocyanate, 2,6-tolylene diisocyanate, 1,3-xylylene diisocyanate, 1,4-xylylene diisocyanate, diphenylmethane-4,4'-diisocyanate, 3-methyldiphenylmethane diisoocyanate and 1,5-naphthalene diisocyanate; alicyclic diisocyanate compounds such as dicyclohexylmethane diisocyanate and isophorone diisocyanate; aliphatic diisocyanate compounds such as hexamethylene diisocyanate and lysine diisocyanate; compounds obtained by hydrogenating the above various diisocyanate compounds containing the aromatic ring, for example, difunctional diisocyanate compounds such as hydrogenated xylylene diisocyate and hydrogenated phenylmethane-4,4-diisocyanate; polyisocyanate compounds obtained by addition-reaction of these diisocyanate compounds with di- to hexa-valent lower alcohols typified by trimethylolpropane so that 1 equivalent of the hydroxyl group is addition-reacted with 2 equivalents of the isocyanate group; biuret-type polyisocyanate compounds obtained by reacting a diisocyanate compound with water; trifunctional isocyanate compounds such as 2-isocyanate ethyl-2,6-diidocyanate hexanoate; and polymers obtained by isocyanurating the diisocyanate compound.

Typical examples of the compound having both an unsaturated bond and a hydroxyl group include 2-hydroxyethyl (meth)acrylate, 2-hydroxypropyl (meth)acrylate, 2-hydroxybutyl (meth)acrylate, 4-hydroxybutyl (meth)acrylate, polyethylene glycol mono(meth)acrylate, polypropylene glycol, mono(meth)acrylate, pentaerythritol di(meth)acrylate, pentaerythritol tri(meth)acrylate, glycerol mono(meth)acrylate, glycerine di(meth)acrylate, glycidyl (meth)acrylate-(meth)acrylic acid adduct, "ARONIX M-154" [epsilon-caprolactone-modified 2-hydroxyethyl (meth)acrylate produced by Toa Gosei Kagaku Kogyo, K.K.], tris(2-hydroxyethyl) isocyanurate-di(meth)acrylate, and N-methylol (meth)acrylamide. Other examples include unsaturated polyesters obtained by polycondensation between unsaturated carboxylic acids such as maleic acid, maleic anhydride, fumaric acid, citraconic acid, citraconic anhydride, itaconic acid and itaconic anhydride and low-molecular-weight diols such as ethylene glycol, propylene glycol, 1,6-hexanediol or 3-methyl-1,5-pentanediol.

Amongst resins having a cyclocarbonate group, an alpha-beta ethylenically unsaturated group and an urethane bond per molecule, those obtained by introducing a cyclocarbonate group into a polyurethane (meth)acrylate resin having excellent film roughness and chemical resistance have particuarly marked improved adhesion (intimate adhesion) to various materials and paricularly marked improved dispersibility of various inorganic fillers, and are therefore especially desirable active energy ray-curable resins.

The suitable cyclocarbonate group content of the resin used in compositions of the invention is usually 0.05 to 1.5 equivalents per 1,000 grams of the resin solids. In particular, 0.1 to 1 equivalent is suitable from the standpoint of high adhesion to various materials and a high improving effect of the dispersibility of inorganic fillers, and further from the standpoint of the fact that the resins are easy to dissolve in various reactive diluents such as tetrahydrofurfuryl (meth)acrylate, tripropylene glycol di(meth)acrylate or pentaertythritol tri(meth)acrylate and versatile organic solvents such as toluene, methyl ethyl ketone, methyl isobutyl ketone, ethyl acetate and butyl acetate.

If required, an organic solvent and/or a reactive diluent may be added to the resin having a cyclocarbonate group, an alpha-beta ethylenically unsaturated bond and a urethane bond per molecule.

The present invention therefore further provides an active energy ray curable composition as defined above, which further comprises an organic solvent and/or a reactive diluent as essential components.

Typical examples of the organic solvent are aromatic hydrocarbons such as toluene and xylene; ketones such as methyl ethyl ketone, methyl isobutyl ketone and cyclohexanone; esters such as methyl acetate, ethyl acetate and butyl acetate; alcohols such as methanol, ethanol, propanol and butanol; Cellosolve acetate; carbitol acetate; dimethylformamide; and tetrahydrofuran.

Typical examples of the reactive diluent include 2-hydroxyethyl (meth)acrylate, 2-hydroxylpropyl (meth)acrylate, 2-ethylhexyl (meth)acrylate, N-vinyl-pyrrolidone, tetrahydrofurfuryl (meth)acrylate, carbitol (meth)acrylate, phenoxyethyl (meth)acrylate, dicyclopentadiene (meth)acrylate, 1,3-butanediol di(meth)acrylate, 1,6-hexanediol di(meth)acrylate, polyethylene glycol di(meth)acrylate, hydroxypivalate neopentyl glycol di(meth)acrylate, trimethlolpropane tri(meth)acrylate, pentaerythritol tri(meth)acrylate, pentaerythritol tetra(meth)acrylate, and dipentaerythritol hexa(meth)acrylate.

Other components employed in compositions of the invention typically include, for example, photo(polymerization) initiators, polymers, reactive oligomers, polymerization inhibitors, antioxidants, dispersing agents, surface-active agents, inorganic fillers, inorganic pigments and organic fillers.

The present invention further provides a process which comprises curing a resin composition of the invention, as described above, by irradiating said resin with ionising radiation or active energy rays.

To cure the resin composition of this invention by using ultraviolet rays as the active energy rays, a photo(polymerization) initiator should be used which is dissociated under the irradiation of ultraviolet light having a wavelength of 1,000 to 8,000 Å to generate radicals. Such a photo(polymerization) initiator may be of any known type. Typical examples thereof include acetophenones, benzophenones, Michler's ketone, benzyl, benzoin benzoate, benzoin, benzoin methyl ethers, benzyl dimethyl ketals, alpha-acryloxime esters, thioxanthones, anthraquinones and derivatives of these. Such photo(polymerization) initiators may be used in combination with known sensitizers. Typcal examples of the sensitizers include amines, ureas, sulfur-containing compounds, phosphorus containing compounds, chlorine compounds and nitriles, and other nitrogen compounds.

The polymers that can be added are saturated or unsaturated and may be added to improve the cured coated film. Examples thereof may include acrylic resins, polyester resins, polyamide resins, epoxy resins, polyurethane resins, vinyl chloride/vinyl acetate copolymers, polyvinyl butyral resins, cellulosic resins and chlorinated polypropylene resins.

The reactive oligomers include, for example, compounds having an isocyanate group in the molecule, compounds having a (meth)acryloyl group, or compounds having an isocyanate group and a (meth)acryroyl group.

Typical examples of the fillers include body extender pigments such as barium sulfate, barium carbonate, gypsum, alumina white, clay, silica, talc, calcium silicate and magnesium carbonate; chromates such as chrome yellow, zinc chromate and molybdate orange; ferrocyanides such as Prussian blue; metal oxides such as titanium oxide, red iron oxide, iron oxide, zinc oxide and chromium oxide green; metal sulfates such as cadmium yellow, cadmium red and cadmium mercury red; sulfates such as lead sulfate; silicates such as Prussian blue; carbonates such as calcium carbonate; phosphates such as cobalt violet and manganese violet; metal powders such as aluminum powder, zinc powder, brass powder, magnesium powder, iron powder, copper powder and nickel powder; inorganic pigments such as carbon black; and organnic pigments such as azo pigments, copper phthalocyanine pigments (phthalocyanine blue and phthalocyanine green) and quinacridone pigments.

The active energy rays used in this invention generically denote ionizing radiations or light such as electron rays, beta-rays, gamma-rays, X-rays, and ultraviolet-rays. The so-obtained active energy ray-curable resin composiiton of this invention may be cured by irradiating ionizing radiation or active energy rays by using the above-mentioned active energy sources.

The active ray energy-ray curable resin composition of this invention may be utilized as a binder for a paint, an adhesive, a printing ink or a magnetic recording medium. The invention therefore further provides a paint, an adhesive, a printing ink or a magnetic recording medium which contains a resin composition of the invention as described above.

Now, the present invention will be more specifically described below by Referential Examples, Examples, Comparative Examples, Application Examples and Comparative Application Examples, In these examples, all parts are based on weight.

### REFERENTIAL EXAMPLE 1

Example of preparing a polyester diol:-

A four-necked flask having a capacity of 500 ml was charged with 180 g of 1,4-butanediol and 130 g of adipic acid. Nitrogen gas was blown lightly into the reaction system to shut off the inflow of air.

While the water of condensation was distilled off out of the reaction system, the esterification reaction was carried out for 2 hours at 170°C and for 8 hours at 210°C to obtain a product having a hydroxyl value of 160 and an acid value of 0.2.

### REFERENTIAL EXAMMPLE 2

Example of a diol monomer containing a cyclocarbonate group:-

A 500 ml four-necked flask was charged with 210 g of epichlorohydrin and 0.1 g of tetraammonium chloride. While the temperature of the reaction mixture was controlled to 40°C, 150 g of diethanolamine was added dropwise over 30 minutes.

After the addition, the reaction was continued by maintaining the same temperature for 6 hours, and the unreacted epichlorohydrin was extracted and removed with toluene to obtain 322 g of an extraction residue having a nonvolatile content of 87 %.

Then, 150 g of the extraction residue and 90 g of sodium hydrogen carbonate were charged into a four-necked flask. With stirring, the reaction mixture was maintained at 90°C for 1 hour to filter the insoluble matter such as sodium hydrocen carbonate or sodiuim chloride and remove it. Dimethylformamide in the filtrate was extracted with toluene to obtain 110 g of the extraction residue having a nonvolatile content of 76 %.

Then, the nonvolatile component was analyzed by infrared absorption spectrum (IR), magnetic resonance spectrum (NMR) and gas chromatography mass spectrum (GC-MS). It was identified that the product was N-glyceryl cyclocarbonate diethanolamine with the structure of the following formula (VI) 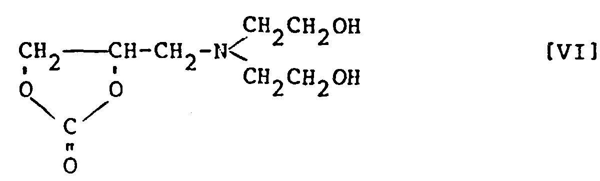 having a specific absorption at 1,800 cm⁻¹.

### REFERENTIAL EXAMPLE 3

Example of preparing glyceryl carbonate methacrylate:-

A 500 ml four-necked flask was charged with 110 g of glycerol-alpha-monochlorohydrin, 100 g of dimethyl formamide, and 120 gram of sodium hydrogen carbonate, and the reaction was carried out at 100°C for 2 hours. By removing the insoluble matter such as sodium hydrogen carbonate via filtration, a viscous liquid material having a nonvolatile content of 99 % was obtained.

Then, the nonvolatile component was analyzed by IR and NMR. It was identified that the product was hydroxymethylethylene carbonate with the structure of the following formula [VIII] 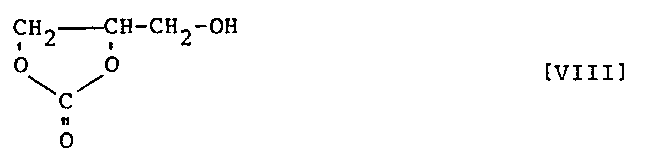 having a specific absorption at 1,800 cm⁻¹.

Subsequently, a 500 ml four-necked flask was charged with 60 g of said hydroxymethylethylene carbonate, 77 g of methacrylic anhydride, 0.1 g of p-toluene-sulfonic acid and 0.04 g of 3,5-di-tert-butyl-4-hydroxy-toluene, and the reaction was conducted at 70°C for 8 hours. Thereafter, 100 g of toluene was added to dilute the reaction mixture.

Then, the reaction mixture was cooled to room temperature, and put in a 1 liter separatory funnel. An aqueous solution of 48 g of sodium hydrogen carbonate in 300 g of water was added thereto, and the mixture was well shaked to neutralize methacrylic acid, followed by removing an aqueous layer.

An oil layer was washed five times with a 10 % sodium chloride aqueous solution, and put in an evaporator where toluene and a moisture were removed by distillation at 40°C and 20 mmHg. There was obtained a yellowish viscous liquid material.

Analysis of the reaction product by IR, NMR and gas chromatography revealed that the product was an intended glyceryl cyclocarbonate methacrylate (purity 98 % or more).

### REFERENTIAL EXAMPLE 4

Example of preparing an isocyanate group-terminated urethane acrylate:-

A four-necked flask fitted with a thermometer, a stirrer and a reflux condenser was charged with 174 g of tolylene diisocyanate, and 130 g of 2-hydroxypropyl acrylate was added dropwise. The reaction was run at 70°C for 4 hours to afford a transparent viscous liquid material. An isocyanate equivalent of this product was 3.3 meq/g.

### REFERENCE EXAMPLE 5

A four-necked flask fitted with a thermometer, a stirrer and a reflux condenser was charged with 50.1 g of polyester diol obtained in Referential Example 1, 11.0 g of N-glyceryl cyclocarbonate diethanolamine obtained in Referential Example 2, 15.0 g of cyclohexanone and 0.02 g of dibutyltin dilaurate. While controlling the temperature in the inside of the system to 70°C, 28.0 g of 4,4'-dicyclohexylmethane diisocyanate was added thereto dropwise, and the reaction was run for 6 hours.

Further, 52 g of cyclohexanone was added, and 10 g of the isocyanate group-terminated urethane acrylate obtained in Referential Example 4 was then added dropwise. The reaction was carried out at 70°C for 5 hours.

Analysis of the thus obtained reaction product revealed that the presence of the isocyanate group was not ascertained at all and the product was a cyclocarbonate group-containing polyurethane acrylate resin having a specific absorption at 1,800 cm⁻¹.

### REFERENCE EXAMPLE 6

Five grams of N-glyceryl cyclocarbonate diethanolamine obtained in Referential Example 2 and 5 g of 3-methyl-1,5-pentanediol were charged in the same reaction vessel as used in Example 1 and well mixed. Further, 6 g of polyester diol obtained in Referential Example 1 and 0.02 g of dibutyltin dilaurate were added thereto and they were well mixed. While controlling the temperature to 70°C, 20 g of tolylene diisocyanate was added thereto dropwise. When about one hour lapsed, the viscosity of the reaction system was increased and stirring became difficult. Accordingly, 67 g of methyl ethyl ketone was charged. While the same temperature was maintained for 4 hours, the reaction was continued.

Subsequently, 12.4 g of the isocyanate group-terminated urethane acrylate obtained in Referential Example 4 was added thereto dropwise, and the reaction was run at 70°C for 5 hours.

Analysis of the thus obtained reaction product by IR revealed that the presence of the isocyanate group was not ascertained at all and the product was a cyclocarbonate group-containing polyurethane acrylate resin having a specific absorption at 1,800 cm⁻¹.

### REFERENCE EXAMPLE 7

The same reaction vessel as used in Exmaple 1 was charged with 50 g of polyester diol obtained in Referential Example 1, 7 g of 1,6-hexanediol, 56 g of methyl ethyl ketone and 0.02 g of dibutyltin dilaurate. The temperature in the inside of the system was maintained at 70°C, and 28 g of 4,4'-dicyclohexylmethane diisocyanate was added dropwise. While the same temperature was maintained for 6 hours, the reaction was continued.

Then, 14 g of the isocyanate group-terminated urethane acrylate obtained in Referential Example 4 was added thereto dropwise. While the above temperature was maintained for 5 hours, the reaction was run.

Further, 10 g of glyceryl cyclocarbonate methacrylate obtained in Referential Example 3 was added thereto and the reaction was continued.

Analysis of the thus obtained reaction product by IR revealed that the presence of the isocyanate group was not ascertained at all and the product was a cyclocarbonate group-containing polyurethane acrylate resin having a specific absorption at 1,800 cm⁻¹.

### REFERENCE EXAMPLE 8

The same reaction vessel as used in Example 1 was charged with 100 g of "EPICLON N-665 (a tradename for a cresol novolak-type epoxy resin made by Dainippon Ink and Chemicals, Inc.), 35 g of methyl isobutyl ketone and 0.06 of N,N-dimethylbenzylamine, and they were well dissolved. While keeping the temperature in the inside of the system at 70°C, 35 g of acrylic acid was added dropwise, and the reaction was carried out.

When an acid value of the reaction system reached 80 KOH mg/g and an epoxy equivalent thereof became 705 g/eq, the reaction solution was well washed with water to remove unreacted acrylic acid.

Subsequently, 25 g of 30 % hydrochloric acid was added dropwise to this system, and the reaction was run at 80°C for 2 hours. The reaction solution was then well washed with water to remove unreacted hydrochloric acid.

Then, methyl isobutyl ketone was removed at 90°C and 20 mmHg to obtain a solid resin having a nonvolatile content of 95 %.

Thereafter, 100 g of dimethylformamide was added thereto and dissolved, and 25 g of sodium hydrogen carbonate was added. The reaction was run at 100°C for 1 hour. The insoluble matter such as sodium hydrogen carbonate was removed by filtration, and dimethylformamide was distilled off from the filtrate by a rotary evaporator to obtain a solid resin having a nonvolatile content of 96 %.

Analysis of the thus obtained resin by IR revealed that the presence of the epoxy group was not found at all and the product was one having a specific absorption at 1,800 cm⁻¹.

This resin was then dissolved in cyclohexanone to form a resin solution having a nonvolatile content of 60 %.

### COMPARATIVE EXAMPLE 1

The same reaction vessel as used in Example 1 was charged with 31 g of tolylene diisocyanate and 0.02 g of dibutyltin dilaurate. While controlling the temperature in the inside of the system to 70°C, 70 g of polyester diol obtained in Referential Example 1 was added thereto dropwise.

The reaction was run at the above temperature for 4 hours to afford an isocyanate group-terminated urethane prepolymer having an isocyanate equivalent of 1.20 meq/g.

Subsequently, 20 g of 2-hydroxyethyl acrylate was added dropwise to the prepolymer, and the urethanization reaction was conducted at the above temperature for 2 hours.

Analysis of the reaction product by IR revealed that the presence of the isocyanate group was not found at all and the absorption at 1,800 cm⁻¹ ascribable to the cyclocarbonate group was not found at all either.

### REFERENCE APPLICATION EXAMPLES 1 to 4 and COMPARATIVE APPLICATION EXAMPLE 1:

Each of the resins obtained in Reference Examples 5 to 8 and Comparative Example 1 and the other components shown in the following formulation were dispersed at 1,000 rpm for 1 hour by a high-speed dispersing device to obtain a paint.

| Formulation | parts |
|---|---|
| "TIPAQUE R-820" (a tradename for rutile titanium oxide made by Ishihara Sangyo K.K.) | 50 |
| Each solid resin | 50 |
| Toluene | 90 |
| Methyl ethyl ketone | 90 |

Subsequently, each of the paints was coated on a polyethylene terephthalate (PET) film and a wet-sanded tinplate separately with a 60-micron applicator, and forcibly dried at 70°C for 1 hour. Electron rays were then irradiated at 6 Mrad to conduct curing.

In the following manner, gloss and adhesion to the PET film and the tinplate were evaluated for the cured coated films. The results are shown in Table 1.

### [Gloss of the coated surface]

It is indicated by a gloss value in reflection of a 60° mirror surface.

### [Adhesion of a coated film]

A coated surface is subjected to a cellophane tape peeling test in a usual manner, and the presence or absence of peeling of the coated surface and a degree of peeling of the coated surface are evaluated with an unaided eye.

The evaluation standard is as follows.
- "excellent"-: Peeling of the coated surface is not observed at all.
- "good"-: A degree of peeling of the coated surface is within 10 % in surface ratio.
- "slightly bad"-: A degree of peeling of the coated surface is within 30 % in surface ratio.
- "bad"-: A degree of peeling of the coated surface exceeds 30 % in surface ratio.

### REFERENCE APPLICATION EXAMPLES 5 to 8 and COMPARATIVE APPLICATION EXAMPLE 2:

To each of the resins obtained in Reference Examples 5 to 8 and Comparative Example 1 was added 3 %, based on the solids content of each of the resins, of "IRGACURE 651" (a tradename for benzyl dimethyl ketal made by Ciba Geigy, Switzerland), and they were thoroughly mixed with each other. The mixture was then coated on a PET film and a wet-sanded tinplate separately by a 60-micron applicator, forcibly dried at 70°C for 1 hour, and irradiated with a medium pressure mercury arc lamp at 2,000 mJ/cm² at a distance of 15 cm to obtain a cured coated film.

Subsequently, adhesion was evaluated for the coated films in the same way as in Application Examples 1 to 4 and Comparative Application Example 1. The results are shown in Table 2.

### REFERENCE EXAMPLE 9

The same reaction vessel as used in Reference Example 5 was charged with 50.1 g of polyester diol obtained in Referential Example 1, 11.0 g of N-glyceryl cyclocarbonate diethanolamine obtained in Referential Example 2, 15.0 g of tetrahydrofurfuryl methacrylate and 0.02 g of dibutyltin dilaurate. While maintaining the temperature in the inside of the system at 70°C, 28.0 g of 4,4'-dicyclohexylmethane diisocyanate was added dropwise, and the reaction was run at the same temperature for 6 hours.

Further, 52.0 g of tetrahydrofurfuryl methacrylate was added, and 10.0 g of the isocyanate group-terminated urethane acrylate obtained in Referential Example 4 was added dropwise. The reaction was conducted at 70°C for 5 hours.

Analysis of the resulting reaction product by IR revealed that the presence of the isocyanate group was not found at all and the product was a cyclocarbonate group-containing polyurethane acrylate having a specific absorption at 1,800 cm⁻¹.

### REFERENCE APPLICATION EXAMPLE 9

In the same way as in Reference Application Examples 1 to 4 and Comparative Application Example 1, a paint was prepared except using the resin obtained in Reference Example 9, coated, forcibly dried and irradiated with electron rays to obtain a cured coated film. The coated film was evaluated as above. The results are shown in Table 1.

### REFERENCE APPLICATION EXAMPLE 10

In the same way as in Reference Application Examples 5 to 8 and Comparative Application Example 2, a paint was prepared except using the resin obtained in Reference Example 9, coated, and irradiated with ultraviolet rays to obtain a cured coated film. The coated film was evaluated as above. The results are shown in Table 2.

From the results in Tables 1 and 2, it follows that the active energy ray-curable type resin compositions of this invention can give the coated films excellent in dispersibility and adhesion in particular.

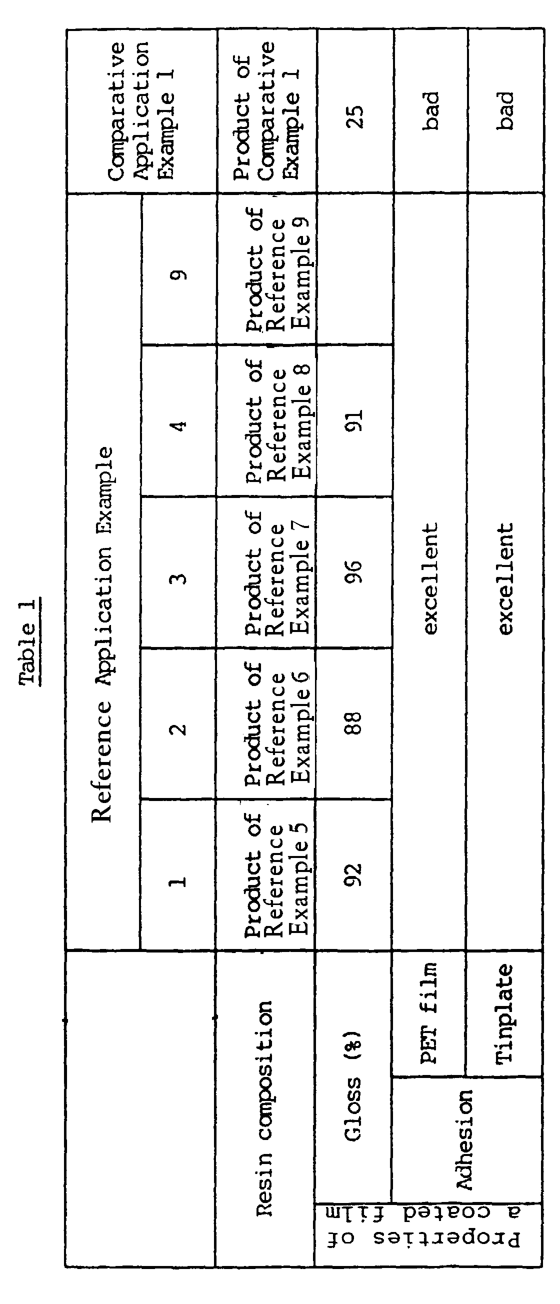

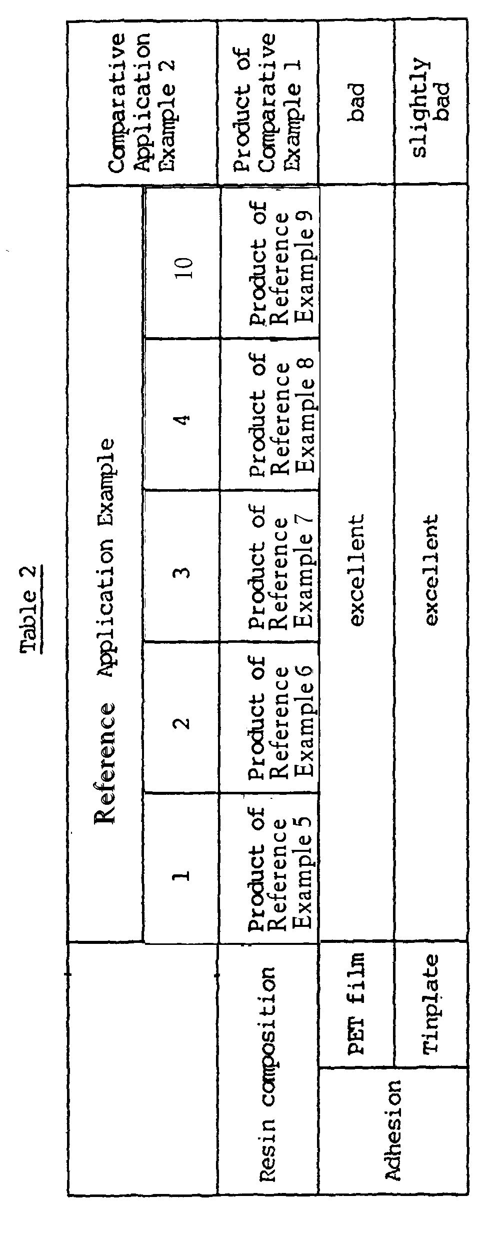

## Claims

1. An active energy ray-curable composition comprising a resin having a cyclocarbonate group, an alpha,beta-ethylenically unsaturated double bond and an urethane bond in the molecule as an essential film-forming component, the resin being obtainable by reacting together (i) a diol having a molecular weight of 500 to 4000, (ii) a diol containing a cyclocarbonate group, (iii) an isocyanate compound, and (iv) a compound having an unsaturated bond and a hydroxyl group.

2. A composition according to claim 1 which further comprises an organic solvent and/or a reactive diluent as essential components.

3. A composition according to any one of the preceding claims wherein the cyclocarbonate group content in the resin is from 0.05 to 1.5 equivalents per 1000 g of the resin solids.

4. A composition according to any one of the preceding claims wherein the cyclocarbonate group content in the resin is from 0.1 to 1 equivalents per 1000 g of the resin solids.

5. A composition according to any one of the preceding claims wherein the diol having a molecular weight of 500 to 4000 is selected from polyester-type diols, polyether-type diols and caprolactame-type diols.

6. A process which comprises curing the resin composition as claimed in any one of the preceding claims by irradiating said resin with ionizing radiation or active energy rays.

7. A paint, an adhesive, a printing ink or a magnetic recording medium which contains a resin as claimed in any one of claims 1 to 5 as a binder.

## Patentansprüche

1. Durch aktive Energiestrahlung härtbare Masse, umfassend ein Harz mit einer Cyclocarbonatgruppe, einer α,β-ethylenisch ungesättigten Doppelbindung und einer Urethanbindung im Molekül als wesentliche filmbildende Komponente, wobei das Harz erhältlich ist durch Umsetzung von (i) einem Diol mit einem Molekulargewicht von 500 bis 4000, (ii) einem Diol, enthaltend eine Cyclocarbonatgruppe, (iii) einer Isocyanatverbindung und (iv) einer Verbindung mit einer ungesättigten Bindung und einer Hydroxylgruppe.

2. Masse nach Anspruch 1, die ferner ein organisches Lösungsmittel und/oder ein reaktionsfähiges Verdünnungsmittel als wesentliche Bestandteile enthält.

3. Masse nach einem der vorangehenden Ansprüche, wobei der Gehalt an Cyclocarbonatgruppen in dem Harz 0,05 bis 1,5 Äquivalent pro 1000 g der Harzfeststoffe beträgt.

4. Masse nach einem der vorangehenden Ansprüche, wobei der Gehalt an Cyclocarbonatgruppen in dem Harz 0,1 bis 1 Äquivalent pro 1000 g der Harzfeststoffe beträgt.

5. Masse nach einem der vorangehenden Ansprüche, wobei das Diol mit einem Molekulargewicht von 500 bis 4000 ausgewählt ist aus Diolen vom Polyestertyp, Diolen vom Polyethertyp und Diolen vom Caprolactantyp.

6. Verfahren, umfassend die Härtung der Harzmasse nach einem der vorangehenden Ansprüche durch Bestrahlung des Harzes mit ionisierender Strahlung oder aktiver Energiestrahlung.

7. Anstrichmittel, Klebemittel, Drucktinte oder magnetisches Aufzeichnungsmedium, enthaltend ein Harz nach einem der Ansprüche 1 bis 5 als Bindemittel.

## Revendications

1. Composition durcissable par des rayons actifs qui comprend une résine comportant un groupe cyclocarbonate, une double liaison α, β - éthylénique et une liaison uréthanne dans la molécule, comme composant principal qui forme un film, la résine pouvant être obtenue en faisant réagir ensemble (i) un diol présentant une masse moléculaire de 500 à 4000, (ii) un diol contenant un groupe cyclocarbonate, (iii) un composé isocyanate, et (iv) un composé présentant une liaison insaturée et un groupe hydroxyle.

2. Composition conforme à la revendication 1, qui comprend en outre un solvant organique et/ou un diluant réactif comme composants principaux.

3. Composition conforme à l'une quelconque des revendications précédentes, dans laquelle la teneur en groupe cyclocarbonate dans la résine est comprise entre 0,05 et 1,5 équivalents pour 1000 g de matières solides résineuses.

4. Composition conforme à l'une quelconque des précédentes revendications, dans laquelle la teneur en groupe cyclocarbonate dans la résine est comprise entre 0,1 et 1 équivalent pour 1000 g de matières solides résineuses.

5. Composition conforme à l'une quelconque des précédentes revendications, dans laquelle le diol présentant une masse moléculaire de 500 à 4000 est choisi parmi les diols de type polyester, diols de type polyéther et diols de type caprolactame.

6. Procédé qui comprend le durcissement d'une composition de résine conforme à l'une quelconque des précédentes revendications en irradiant ladite résine avec un rayonnement ionisant ou des rayons actifs.

7. Peinture, adhésif, encre pour impression ou milieu d'enregistrement magnétique qui contient une résine conforme à l'une quelconque des revendications 1 à 5 comme liant.
